# EUROPEAN PATENT APPLICATION

(11) **EP 4 492 198 A1**
(43) Date of publication of application: **15.01.2025**
(21) Application number: 24188194.5
(22) Date of filing: 12.07.2024
(51) Int. Cl.: G06F 1/26, G06F 1/18, H05K 7/14, H02J 13/00

(54) **INTELLIGENT POWER APPLIANCE COUPLER**

(30) Priority: 13.07.2023 US 202363526583 P
(71) Applicant: Vertiv Corporation, Columbus, OH 43085 (US)
(72) Inventor: FERGUSON, Kevin, Dublin (US); MICEK, Jeff, Lincoln (US); GILSON, Casey, Omaha (US)
(74) Representative: Beal, James Michael

(57) **Abstract**

A system comprising a power appliance coupler and a rack power distribution unit (rPDU) are provided. The power appliance coupler includes a plug connector configured to connect to a power outlet of the rPDU, a power outlet port; a microprocessor and a memory; an infrared (IR) receiver port configured to receive data via an IR signal and to communicate the received data to the microprocessor; an IR transmitter port configured to transmit output data from the microprocessor as an IR signal; a voltage sensor operatively coupled to the microprocessor; and a current sensor operatively coupled to the microprocessor. The rPDU includes an input power supply cord, an interchangeable monitoring device (IMD), a non-volatile memory, and a plurality of power outlets and is operatively coupled to the power appliance coupler via a wired connector.

## Description

### CROSS-REFERENCES TO RELATED APPLICATIONS

This patent application claims priority to US Provisional Patent Application Serial No. 63/526,583, filed July 13, 2023.

### TECHNICAL FIELD

Apparatuses and methods consistent with example embodiments relate to a power coupler device and more particularly to an intelligent power appliance coupler that interfaces with a non-intelligent, basic power rack distribution unit (rPDU).

### BACKGROUND

In a modern data center there are frequently dozens, hundreds, or even thousands of electrically powered devices being operated at a given time. Such devices may include servers, network switches, routers, and a wide variety of other data center components. Typically two or more such devices are coupled to a rack power distribution unit (rPDU), which is sometimes also referred to as an "intelligent power strip." A modern day rPDU is rack mountable in a standard equipment rack and typically includes a plurality of alternating current (AC) power outlets. The rPDU distributes received AC power from an AC supply source in the data center to one or more data center devices which have their AC power cords coupled to the PDU's AC power outlets, and which are also typically mounted in the same equipment rack as the rPDU. The rPDU may include its own electronic controller which can communicate with other upstream devices. The rPDU also may include an independently controllable power switch, controllable by its associated controller, which enables each outlet of the rPDU to be independently turned on and off. This capability enables the rPDU to be commanded by an upstream device or application to selectively turn on and off AC power to an associated AC receptacle of the rPDU, to thus control power applied to a specific data center device that is powered from that specific AC power outlet of the rPDU. This controller-commanded On/Off switching capability enables various data center devices being powered from a given rPDU to be power cycled on and off remotely by a data center worker through a suitable control application.

### SUMMARY

Example embodiments may address at least the above problems and/or disadvantages and other disadvantages not described above. Also, example embodiments are not required to overcome the disadvantages described above, and may not overcome any of the problems described above.

An aspect of the disclosed embodiments includes a power appliance coupler that includes: a plug connector configured to connect to a power outlet; a power outlet port; a microprocessor; an infrared (IR) receiver port configured to receive data via an IR signal and to communicate the received data to the microprocessor; an IR transmitter port configured to transmit output data from the microprocessor as an IR signal; a voltage sensor operatively coupled to the microprocessor, and a current sensor operatively coupled to the microprocessor.

Another aspect of the disclosed embodiments includes a power appliance coupler system that includes: a rack power distribution unit (rPDU) comprising: an input power supply cord, an interchangeable monitoring device (IMD), and a plurality of power outlets; and a coupler communicatively coupled to the rPDU; wherein the coupler comprises: a plug connector configured to connect to one of the plurality of power outlets of the rPDU, a power outlet port, a microprocessor, an infrared (IR) receiver port configured to receive data via an IR signal and to communicate the received data to the microprocessor, an IR transmitter port configured to transmit output data from the microprocessor as an IR signal, a voltage sensor operatively coupled to the microprocessor, and a current sensor operatively coupled to the microprocessor.

Another aspect of the disclosed embodiments includes a computer-readable medium storing thereon a program which, when executed by a processor causes a power appliance coupler to: establish communication with a host of a rack power distribution unit (rPDU); receive an assigned index and configuration information from the host; establish communication with a downstream coupler; assign a next index to the downstream coupler; transmit the configuration information to the downstream coupler; receive data and status information from the downstream coupler; determine a phase relationship and a circuit relationship with the downstream coupler; and transmit phase relationship and circuit relationship information to the host.

### BRIEF DESCRIPTION OF THE DRAWINGS

The above and/or other aspects will become apparent and more readily appreciated from the following description of example embodiments, taken in conjunction with the accompanying drawings in which:
FIG. 1 is a perspective view of a rack power distribution unit (rPDU) and attached couplers according to the principles of the present disclosure;
FIGS. 2A-2C are partial perspective views of the rPDU and attached couplers of FIG. 1;
FIG. 3 is a perspective view of a front of an rPDU according to the principles of the present disclosure;
FIG. 4 is a perspective view of a rear of the rPDU of FIG. 3 and attached couplers according to the principles of the present disclosure;
FIG. 5 is a perspective view of a coupler including a non-detachable power cord according to the principles of the present disclosure;
FIG. 6 is a perspective view of a coupler including an integral plug connector outlet according to the principles of the present disclosure;
FIG. 7 is a block diagram of a coupler according to the principles of the present disclosure;
FIG. 8 is an outlet power wiring schematic according to the principles of the present disclosure; and
FIGS. 9-11 are examples of logic applied for a four-outlet gap rule, a three-outlet gap rule, and a two-outlet gap rule, respectively, the principles of the present disclosure.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including", "comprise, and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list. In addition, the terms such as "unit," "-er (-or)," and "module" described in the specification refer to an element for performing at least one function or operation, and may be implemented in hardware, software, or the combination of hardware and software.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described here in detail.

In a modern-day data center there are frequently dozens, hundreds or even thousands of electrically powered devices being operated at a given time. Such devices may be servers, network switches, routers, and a wide variety of other data center components.

A rack power distribution unit (rPDU) can be used in racks that hold electronic equipment such as servers. An rPDU, sometimes referred to as a power strip, is typically used in a data center environment, with one or more units installed in racks arranged in rows, to power Internet Technology equipment (ITE). A single rPDU may provide power to dozens of devices per rack via outlet sockets, and an intelligent rack PDU employed in a data center can measure and control the loads.

An intelligent power appliance coupler which interfaces to an rPDU may provide flexible, ad hoc integration of custom outlet metering and switching capabilities as needed by an end user. In this way, electronics that may have been included in an intelligent rPDU can be incorporated into the coupler, enabling the coupler to control the product and provide metering and other features that may have been provided by the intelligent rPDU. Such a coupler may be used with a basic rPDU, enabling the rPDU to have a simpler design and redistributing the intelligence to the coupler, or the coupler may be used with a somewhat less intelligent rPDU that may have some basic metering and control capability. Features provided by the coupler may include, for example, metering and/or wireless communications.

A coupler according to one or more example embodiments interfaces with a non-intelligent basic rPDU to provide flexible, ad hoc integration of custom outlet metering and switching capabilities, as needed.

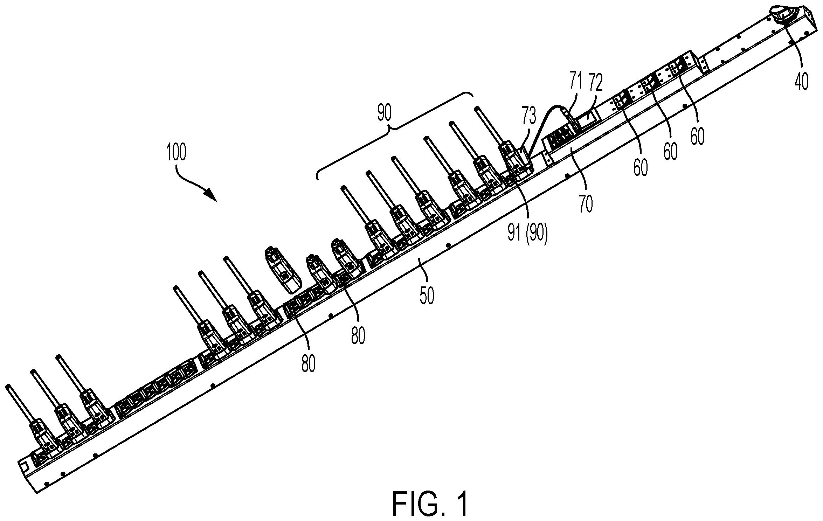

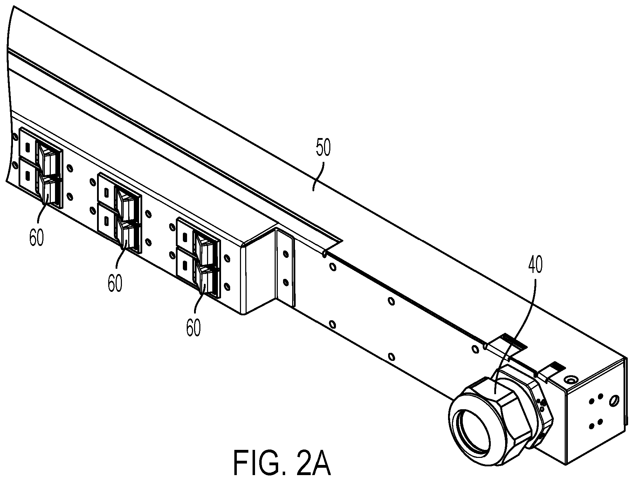

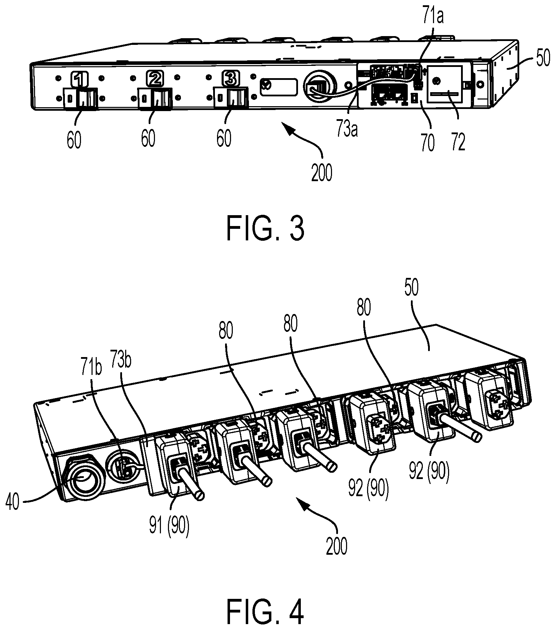

FIGS. 1 and 2A-2C are views of an rPDU 100 and a plurality of couplers attached thereto according to an example embodiment. The illustrated rPDU 100 is a basic, vertical rPDU, but this is merely an example. A horizontal rPDU may be used, as seen, for example, with respect to FIGS. 3 and 4, discussed below. The rPDU 100 of FIGS. 1 and 2A-2C includes a chassis 50, a three-phase input power supply cord (not shown) connected at an end of the chassis 50 of the rPDU 100, an internal terminal block (internal and not shown) to terminate four current carrying power conductors (internal and not shown) and to split these into twelve branch circuits (internal and not shown), an internal power supply (internal and not shown) for an interchangeable monitoring device (IMD) 72, a non-volatile memory (NVM) module (internal and not shown), a plurality circuit breakers 60, an IMD installation compartment 70, and a plurality of contiguous banks of outlets 80. A serial-to-infrared (IR) adaptor cable 73 connects between a universal serial bus (USB) Type A port 71 of the IMD 72 and a primary one 91 of the plurality of couplers 90. Alternately, the IMD 72 and the primary coupler 91 may be connected wirelessly via, for example, radio frequency wireless communication and/or Bluetooth wireless communication.

The three-phase input power supply cord (not shown) enters the rPDU 100 at the strain relief 40. Any of a variety of wires and sizes thereof are compatible with the rPDU 100. The internal terminal block may be installed on an internal printed circuit board (PCB) near the strain relief 40 to land the power supply cord wires. From there the branch circuit wires can propagate within the rPDU chassis 50 and connect to the circuit breakers 60 and then to the outlets 80. According to an example aspect, the branch circuits may include or consist of the wiring between the outlets 80, e.g., the line side of the circuit breakers 60, and the terminal block. The internal power supply may be mounted on the internal PCB provide power to the IMD.

Four current carrying power conductors may split into twelve branch circuits. However, these numbers are merely examples, and there may be more or fewer power conductors and/or branch circuits as would be understood by one of skill in the art. Likewise, six circuit breakers are shown, but this is an example, and there may be more or fewer circuit breakers. The circuit breakers may be, for example, single-pole hydraulic magnetic circuit breakers. Alternately, the circuit breakers may be another type of single-pole breakers, three-pole breakers, thermal breakers, or any of a variety of other types. Additionally, the illustrated rPDU 100 is a vertical type and includes 36 outlets, but these are examples. The rPDU may be a horizontal type, and there may be more or fewer outlets.

FIGS. 3 and 4 are perspective views of a front and a rear, respectively, of a horizontal basic rPDU 200 and attached couplers. Elements of the horizontal rPDU 200 which are the same, though organized and positioned differently, as those of the rPDU 100 are labeled with the same reference numbers. The rPDU 200 may include a chassis 50, a three-phase input power supply cord (not shown) connected to a strain relief 40 at a rear of the chassis 50, an internal terminal block (not shown) to terminate four current carrying power conductors and to split these into three branch circuits, an internal power supply (not shown) for an IMD 72, an NVM module (not shown), three circuit breakers 60, an IMD installation compartment 70, and two contiguous banks of six outlets 80 organized into a single tier or into two outlet banks. A first USB plug/socket connector 73a may be mounted to a front side of the chassis 50, near the IMD compartment 70 and may be coupled to the IMD 72 at its USB Type A connector 71a. A second USB plug/socket bulkhead connector 71b may be mounted on the rear of the chassis 50. A serial-to-IR adaptor cable 73b may be connected between the second USB connector 71b and a primary one 91 of the plurality of couplers 90.

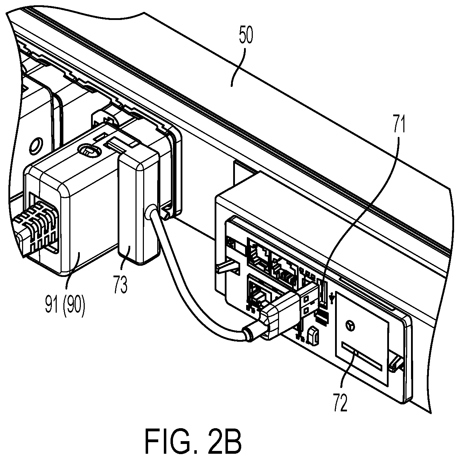

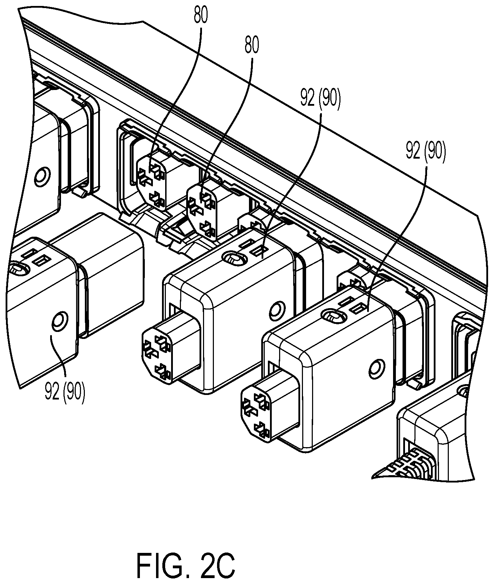

As discussed above with respect to FIGS. 1 and 2, the number of power conductors, branch circuits, circuit breakers, and outlets shown in FIGS. 3 and 4 are merely examples, and there may be more or fewer, as would be understood by one of skill in the art.

An rPDU including multiple tiers of outlets may further include an IR light pipe extender flange (not shown), with that extender flange further including an embedded light pipe coupling two ports of the extender flange. The flange may be mounted at an end of the chassis 50 of an rPDU bridging adjacent tiers of outlets. The flange may be mounted in a position such that it is aligned with IR ports of the couplers 90 to enable the couplers 90 of multiple tiers to be connected to one another in a serpentine fashion.

The NVM module of the rPDU may be in communication with the IMD in order to save and read nameplate information, power configuration information, and/or power mapping of the rPDU. Such power mapping can include, but is not limited to input voltage and current rating, circuit current rating, number of circuits, type of circuit breaker(s), number of outlets, type of outlets, and/or any of various other features as would be understood by one of skill in the art. The NVM may be a separate module or may be a part of the webcard/IMD. The NVM module may be factory configured.

A non-IMD host may interoperate with the couplers in a similar way as the IMD. The non-IMD host may provide a unique data presentation and support an application programming interfaces (API) to allow manual or custom configuration of the rPDU power mapping and similarly communicate that information to the primary one of the plurality of couplers.

Outside of the IMD/webcard, the switch mode power supply (SMPS) and the NVM, the metering and control electronic technologies may all be outside the rPDU chassis and included within each of the couplers to allow, for example, for a less complex and expeditious assembly of a basic rPDU chassis. This may provide better quality and design for manufacturability for higher first pass yield, reduced test time, and better thermal performance. Alternately, some metering and control electronics may be embedded in the rPDU.

In a coupler according to one or more example embodiments, the components may be encapsulated within an opaque or transparent, colored or not colored, plastic chassis. This may be any plastic meeting an Underwriter Laboratories (UL) 94 flammability rating, or another flammability rating, as would be understood by one of skill in the art. The coupler chassis or body may be hermetically sealed to prevent ingress of moisture and/or fluid.

An intelligent coupler according to one or more example embodiments may include an integral plug connector outlet to couple to a detachable cord or may include a non-detachable cord. A coupler may include a standard parameter(p)-locking retention system.

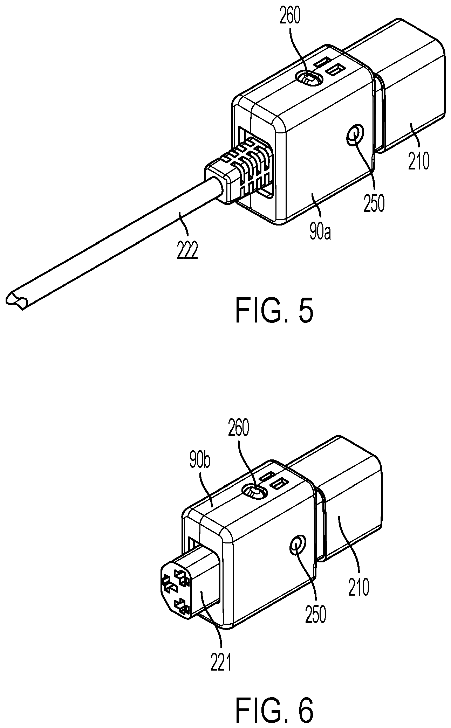

FIG. 5 is a perspective view of a coupler including a non-detachable power cord and, FIG. 6 is a perspective view of a coupler including an integral plug connector outlet according to an example embodiment. Each of the coupler 90a of FIG. 5 and the coupler 90b of FIG. 6 may be used as a primary coupler or a secondary coupler, as discussed in further detail below.

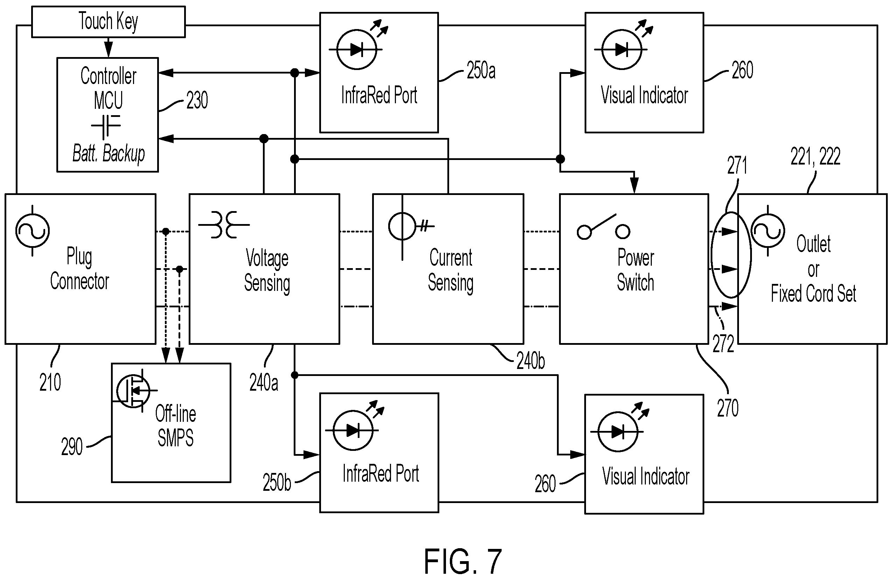

FIG. 7 is a block diagram illustrating a coupler according to one or more example embodiments.

The coupler 90 (90a/90b) of FIGS. 5, 6, and 7 may include an International Electrotechnical Commission (IEC) 60320-1 compatible plug connector 210 and an appliance outlet 221 or a fixed power supply cord 222 including two current carrying conductors 271, and a protective earthing (PE) 272 connected between them with one current carrying conductor 271 operatively coupled to a power relay 270. A microcontroller unit (MCU) 230 manages communications, data acquisition, measurement, power control, and touch and visual interfaces. The MCU 230 may include or be in communication with a static random access memory (SRAM) and a non-volatile read only memory or non-volatile random access memory. It should be understood that the MCU 230 may include or be in communication with any suitable type or amount of memory. The MCU 230 may include a mapping application (not shown) stored on a memory, such as a non-volatile memory (e.g., RAM, ROM, etc.) which is in communication with the MCU 230, or which is incorporated within the MCU itself. As used herein, the non-volatile memory may also be referred to as a computer-readable medium. Sensors 240 may be included to measure voltage and current. A voltage sensor 240a may detect relay contact state output and whether a load is connected or not connected to the coupler 90. A current sensor 240b may be, for example, a toroidal current transformer or a proximity current sensor type. The current sensor 240b may also be a dual toroidal current transformer for load and residual Type A type. The voltage and current sensors 240a and 240b may perform real time root mean square (RMS) voltage measurements and RMS current measurements, respectively. Alternately, the sensors may perform any of a number of other possible voltage and current measurements related to energy metering and power quality analysis.

According to an example aspect, dual IR transceiver ports 250a, 250b are arranged in a repeater topology having one or more internal light pipe segments to direct IR light into an IR transceiver 250.

The coupler 90 may additionally include one or more indicators 260. An indicator 260 may be an audible indicator or a visual indicator, such as a light emitting diode (LED), which may be an RGB LED. The indicator 260 may be operatively connected to the controller 230 to output a signal indicating, via one or more of color and flashing pattern, the comprehensive status or operating condition of the coupler 90. For example, an indicator 260 may indicate a phase relationship, a switching state, a relay contact health, an over and/or under current draw, an open circuit breaker condition, an identification for load balancing, whether communication is outside an operable range (e.g., whether an outlet gap rule is violated), whether an IR transceiver is outside an operable range, and/or any of a variety of other indications as would be understood by one of skill in the art. Because each coupler is connected to the rPDU via an outlet, the visual indicators may be disposed so as to be naturally aligned along a same axis for intuitive association and interpretation of group status.

A bistable Form A single pole, single throw (SPST) power relay 270 makes or breaks a single conductor. Alternately, a Form C single pole, double throw (SPDT) power relay 270 switches to the alternate phase of a single current carrying conductor between the plug connector and appliance outlet or fixed cord set. The relay 270 may switch either pole exclusively.

A coupler may further include a touch sensitive region (not illustrated) to allow for a local change of an individual outlet action or behavior. For example, a touch may control an outlet's switched state during an unloaded condition, e.g., for faster setup and commissioning.

An off-line switched mode power supply (SMPS) 290 may provide low-voltage power supply.

An internal, rechargeable battery (not shown), e.g., a lithium battery, may provide backup power for electronics if outlet power is lost, e.g., during an open circuit breaker condition internal to the rPDU, to convey low-power, or reduced or limited operating mode status.

According to one or more example embodiments, a system may include a single, primary coupler and at least one secondary coupler, operatively coupled to the primary coupler via wireless communication such as IR, supported either internally via a flexible light pipe system or externally through IR transmission between and among couplers through the air. Alternately, wireless communication between/among couplers of a system may be through radio frequency wireless communication and/or Bluetooth wireless communication, and/or another form of wireless communication.

In some embodiments, a primary coupler may provide a serial to IR connection between an IMD or non-IMD host of the rPDU and the one or more secondary couplers. For example, the primary coupler may be operatively coupled, e.g., via a snap fitting, to a serial cable connected to a USB Type A port or USB bulkhead connector of the IMD of the rPDU. The one or more secondary couplers may also include this mating feature, to enable any of the secondary couplers to alternately function as a primary coupler.

Alternately, the primary coupler may support one or more other serial or RF wireless interfaces to enable communication to the IMD or non-IMD host of the rPDU.

Each of the primary and secondary couplers may include an IR Data Association (IrDA) transceiver supporting data rates in a range of about 2.4k to 115.2k baud. Alternately, each of the couplers may include another type of IR transceiver, as would be understood by one of skill in the art.

Each of the couplers is thus configured to function as a repeater with an IR port disposed at each of opposite sides of what may be, for example, the coupler's shortest dimension. A well-designed light pipe can couple at about 80-90% of optical power. In this way, the primary and secondary couplers may exchange information via an IR link over a gap which may have a maximum of about 0.5 -1 meters.

The single primary coupler may be in communication with the IMD 72 of the rPDU 100 to receive power therefrom and mapping information extracted from the NVM and to exchange variable payload including system control information and N-outlets operating status (where N is one or more outlets), energy metering parameters, and/or sets of higher-level, hierarchical aggregated energy metering types, e.g., circuit(s), input(s), phase(s), and/or total energy.

According to one or more example embodiments, each of the one or more secondary couplers is in communication with its nearest upstream and downstream couplers receiving and transmitting a variable payload including its own and downstream couplers operating condition and energy metering parameters, and between on and N-phases x M-circuits sets of partially-aggregated current time series data of downstream couplers having identical phase and circuit relationship.

It may be required that a primary coupler be attached to a designated outlet, e.g., a first outlet, of the rPDU, powered by a first circuit of a first phase, especially designated for this purpose, in order to establish a fixed directionality of secondary coupler discovery order and the absolute phase and circuit origin.

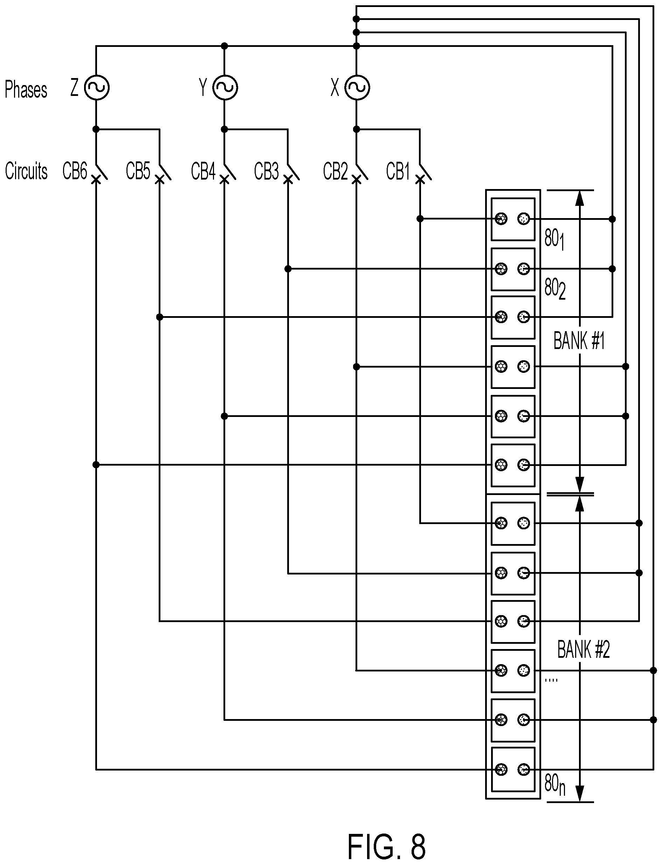

FIG. 8 illustrates an outlet power wiring schematic according to an example embodiment. As shown in FIG. 8, successive outlets 80₁-80ₙ of the rPDU are powered with alternating phase and alternating circuits in an interleaved manner, which encourages inherent three -phase load balancing and an even split of current draw for circuits of the same phase provided a compact stacking arrangement of coupler connectivity is enforced.

As is illustrated, a schematic for an rPDU may include six circuit breakers CB1 through CB6, and two banks of outlets. There are three phases X, Y, and Z, each with two corresponding circuit breakers. A pattern is used in which, for each bank, the X phase circuit CB1 is connected to the first outlet 80₁, Y phase circuit CB3 is connected to the second outlet 80₂, Z phase circuit CB5 is connected to the third outlet, the X phase circuit CB2 is connected to the fourth outlet, the Y phase circuit CB4 is connected to the fifth outlet, and the Z phase CB6 is connected to the sixth outlet. If this pattern is violated, it means that one or more of the outlets may have been skipped. Thus, it may be established that the at least one of the secondary couplers may be installed with no more than a two-to-four outlet gap "rule" between them, and the primary coupler in order to ensure reliable IR communications such that there is less chance of a line-of-sight occlusion blocking or coupler interspacing exceeding limits of the IR transmission power.

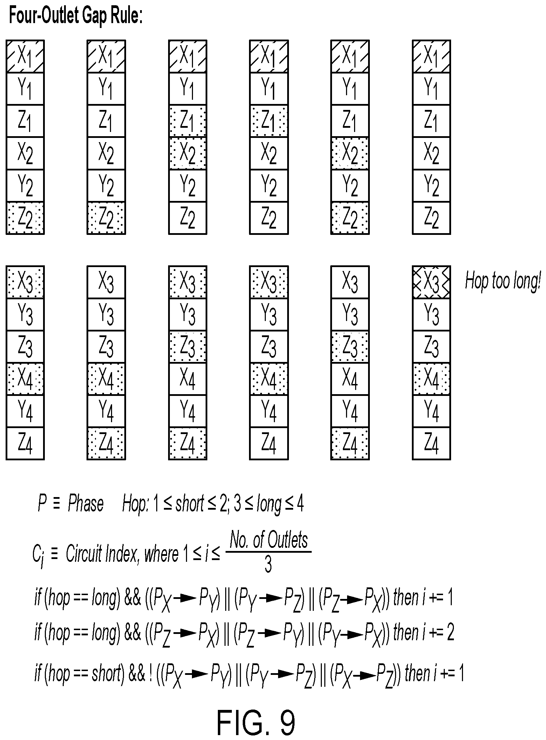

A two-to-four outlet gap rule also allows a secondary couplers circuit-phase relationship to be reliably determined, e.g., the alternating circuit per Triple-N sequence holds for successive couplers having the same phase. FIGS. 9-11 illustrate examples of logic to be applied for a four-outlet gap rule, a three-outlet gap rule, and a two-outlet gap rule, respectively. As can be seen from the figures, a limitation of no greater than a two-outlet gap rule provides for the simplest logic to deduce the circuit-phase relationship and does not require measurement of IR optical power to discriminate a hop distance.

Regarding FIG. 9, where P is phase; a hop of greater than or equal to 1 and less than or equal to 2 is short, and a gap of greater than or equal to 3 and less than or equal to 4 is long; and Cᵢ is a circuit index, where 1 ≤ i ≤ a number of outlets/3; then the circuit-phase relationship and hop distances can be determined using: if (hop == long) && ((P_{X}→P_{Y}) ∥ (P_{Y}→P_{Z}) ∥ (P_{Z}→P_{X})) then i+=1; and if (hop == long) && ((P_{Z}→P_{X}) ∥ (P_{Z}→P_{Y}) ∥ (P_{Y}→P_{X})) then i+=2; and if (hop == short) &&! ((P_{X}→P_{Y}) ∥ (P_{Y}→P_{Z}) ∥ (P_{X}→P_{Z})) then i+=1.

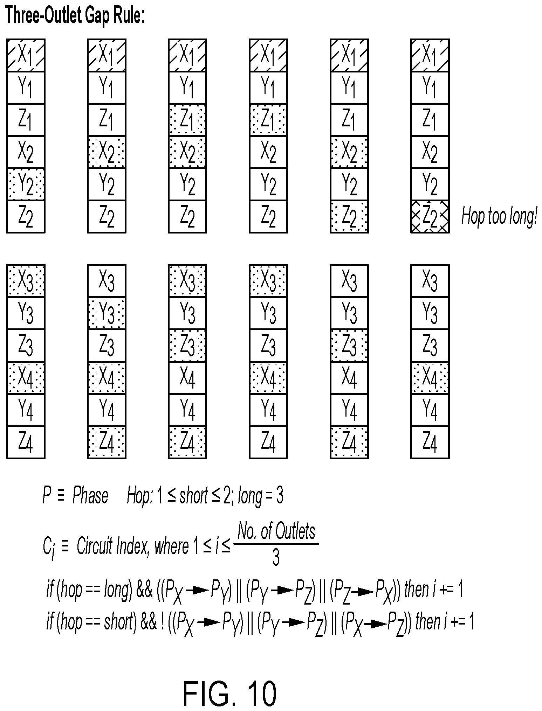

Regarding FIG. 10, where P is phase; a hop of greater than or equal to 1 and less than or equal to 2 is short, and a gap of 3 is long; and Cᵢ is a circuit index, where 1 ≤ i ≤ a number of outlets/3; then the circuit-phase relationship and hop distances can be determined using: if (hop == long) && ((P_{X}→P_{Y}) ∥ (Py->Pz) ∥ (P_{Z}→P_{X})) then i+=1; and if (hop == short) &&! ((P_{X}→P_{Y}) ∥ (P_{Y}→P_{Z}) ∥ (P_{X}-P_{Z})) then i+=1.

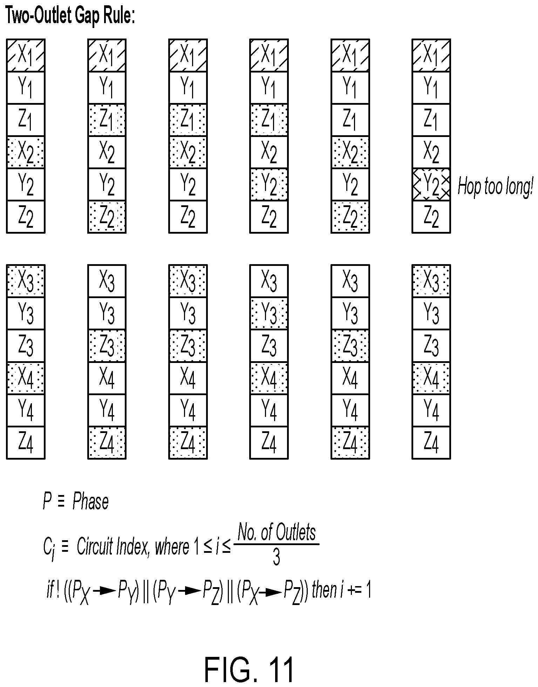

Regarding FIG. 11, where P is phase; 9; and Cᵢ is a circuit index, where 1 ≤ i ≤ a number of outlets/3; then the circuit-phase relationship and hop distances can be determined using: if !(( P_{X}→P_{Y}) ∥ (P_{X}→P_{Z}) ∥ (P_{X}→P_{Z}) then i+=1.

Alternately, rather than the above-described hop-length determination, a range-finding may be performed. For example a range-finding which can resolve a single outlet gap over an entire length of the rPDU may require no gap limitations.

Alternately, according to one or more example embodiments, the circuit-phase configuration may be established using a manual, interactive process in which a user acknowledges or assigns the power mapping via an application programming interface (API).

For models with outlets configured with line voltage only, the outlet polarity may be inverted for alternating circuits to enhance the circuit sorting algorithm so that measurement of IR optical power is unnecessary for three and four outlet gap distances. Outlets configured with phase voltage cannot have their polarity inverted due to UL-62368-1 safety agency Annex G.4.2 deference to IEC 60320-1 family of standards which explicitly defines which poles must be designated line and neutral.

The coupler voltage time series data may be synchronized to its line frequency, so that the zeroth phase corresponds to approximate voltage waveform zero-crossing at the transition from fourth to first quadrant of the sinusoidal. Its zeroth phase current time series data is synchronized to the zeroth phase voltage time series data as well.

The primary coupler can coordinate a run time self-discovery process of all secondary couplers relative phase and circuit relationship - i.e. power mapping, relative to its phase and circuit to eliminate the need to preconfigure the electronic technologies at manufacturing time and to allow for the flexible ad hoc incorporation of couplers by uses as desired. The NVM information helps establish power mapping which can vary among rPDU chassis models. The self-discovery process and mapping may be carried out by the mapping application running on the MCU of the primary coupler.

The couplers can thus determine their relative phase and circuit by correlating their voltage time series data to downstream couplers utilizing a synchronized command to ascertain the relative phase difference between the zeroth phase of their respective voltage time series data. The relative voltage phase difference for three-phase power service is 120° for similarly phased outlets or 30° relative phase difference between line-neutral and line-line phasing for outlets having a same first pole.

A secondary coupler may partially aggregate the current time series data for matching phase and matching circuit of downstream couplers to reduce inter-coupler data traffic.

Coupler-to-outlet enumeration may be inferred by the overall phase and circuit logical relationship established during the discovery process.

The coupler voltage time series data is synchronized to its line frequency, so the zeroth phase corresponds to approximate voltage waveform zero-crossing at the transition from fourth to first quadrant of the sinusoidal. Its zeroth phase current time series data is synchronized to the zeroth phase voltage time series data, too.

In some embodiments, the primary coupler coordinates a run time self-discovery process of all secondary couplers' relative phase and circuit relationship, i.e., power mapping, relative to the primary coupler's own phase and circuit to eliminate a need to preconfigure the electronic technologies at manufacturing time. The NVM information helps establish the power mapping which can vary among rPDU chassis models.

The couplers can each determine their relative phase and circuit by correlating their voltage time series data to downstream couplers utilizing a synchronized command to ascertain the relative phase difference between the zeroth phase of their respective voltage time series data. The relative voltage phase difference for three-phase power service is 120° for similarly phased outlets or 30° relative phase difference between line-neutral and line-line phasing for outlets having the same first pole.

The secondary coupler may partially aggregate the current time series data for matching phase and matching circuit of downstream couplers to reduce inter-coupler data traffic.

In some embodiments, coupler-to-outlet enumeration may be inferred by the overall phase and circuit logical relationship established during the discovery process. Accordingly, explicit knowledge of coupler-to-outlet mapping is not required because the information is unnecessary for intuitive user operation and interaction.

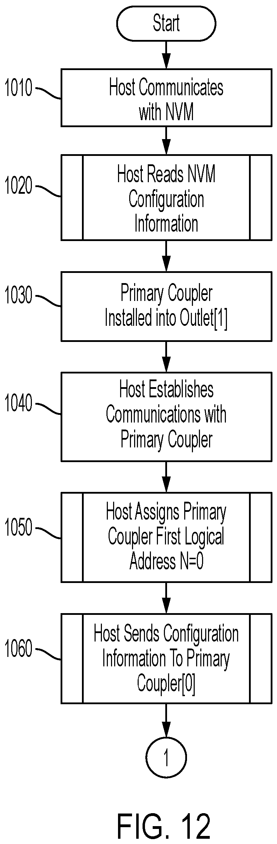

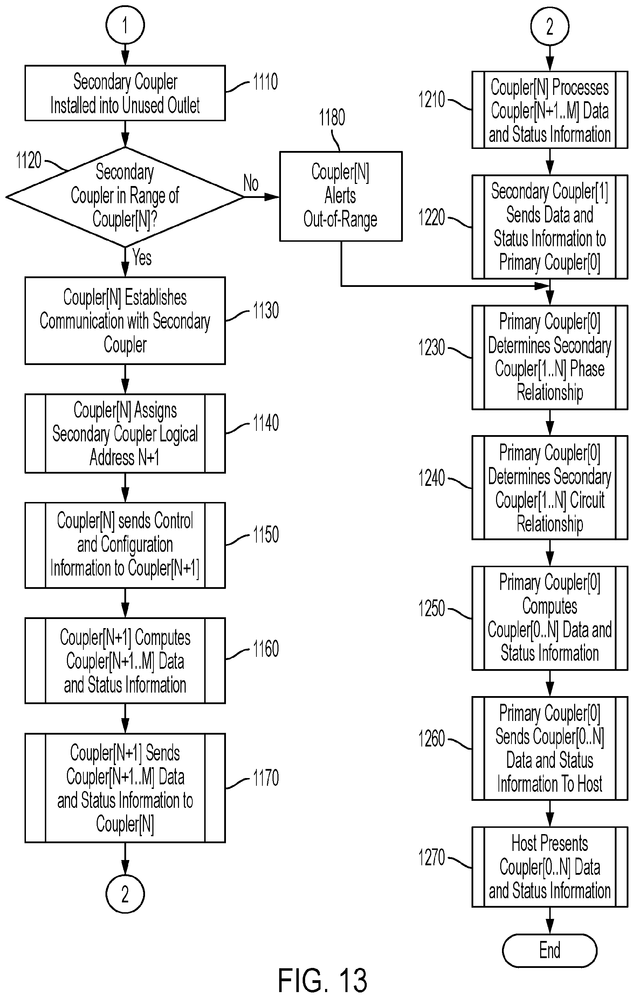

FIGS. 12 and 13 are flow charts representing discovery operations of one or more couplers according to an example embodiment. With reference to FIG. 12, a host (e.g., an IMD as discussed above) of the rPDU communicates with the NVM module of the rPDU (1010) and reads configuration information stored in the NVM module (1020). When a coupler, hereinafter referred to as the primary coupler, is installed into a first or designated outlet of the rPDU (1030), the host is able to establish communication with the primary coupler via, e.g., the adaptor cable 73 (1040). The host then assigns the primary coupler the first logical address, N=0 (1050), where N is used as the index of a coupler. Configuration information stored in the NVM is then transmitted from the host to the primary coupler (1060).

With reference to FIG. 13, when one or more new couplers, hereinafter referred to as secondary couplers, are installed into an unused outlet of the rPDU (1110), if one of the new secondary couplers is within IR communication range of the last-indexed coupler N (1120, yes), the coupler N establishes communication with this closest new secondary coupler (1130). In a case in which only a primary coupler is attached to the rPDU, the primary coupler N=0 functions as the last-indexed coupler. The last-indexed coupler N assigns the next logical address N+1 to this closest secondary coupler (1140) and transmits control and configuration information to the new, secondary coupler N+1 (1150). If there are any further secondary couplers, the coupler N=N+1 uses the control and configuration information provided by coupler N and computes data and status information for downstream couplers N+1 through M, where M is the maximum index of downstream couplers known to the coupler N (1160). the coupler N=N+1 then transmits the data and status information of couplers N=N+1 ... M to the coupler N (1170).

When a new, secondary coupler is installed and is out of range of the last-indexed coupler (1120, no), the last-indexed coupler alerts that there is an out-of-range coupler (1180) and sends data and status information to the primary coupler N=0 (1220). In a case in which the primary coupler is the last-indexed coupler, this operation is omitted. Alternately, in a case in which the last-indexed coupler is N=1, the last-indexed coupler N=1 transmits data and status information to the primary coupler N=0 (1220).

Proceeding from ② in FIG. 13, when the coupler N receives the information of couplers N=N+1 ... M, the data and status information is processed (1210) and sent to the primary coupler N=0 (1220). Having received data and status information, the primary coupler N=0 determines a phase relationship with respect to downstream coupler N (1230) and determines a circuit relationship with respect to downstream coupler N (1240). The primary coupler then computes the data and status information of couplers N=0 ..N (1250) and transmits this information to the host (1260). Finally, the host presents the data and status information (1270).

The methods and operations described above with respect to the primary and secondary couplers may be implemented, for example within the MCU 230 of each of the respective primary and secondary couplers. The MCU may be implemented, at least in part, in digital electronic circuitry, analog electronic circuitry, or in computer hardware, firmware, software, or a combination thereof. These components can be implemented, for example, as a computer program product such as a computer program, program code or computer instructions tangibly embodied in an information carrier, or in a machine-readable storage device, for execution by, or to control the operation of, data processing apparatus such as a programmable processor, a computer, or multiple computers.

A computer program can be written in any form of programming language, including compiled or interpreted languages, and it can be deployed in any form, including as a stand-alone program or as a module, component, subroutine, or other unit suitable for use in a computing environment. A computer program can be deployed to be executed on one computer or other device or on multiple device at one site or distributed across multiple sites and interconnected by a communication network. Also, functional programs, codes, and code segments for accomplishing features described herein can be easily developed by programmers skilled in the art. Method steps associated with the example embodiments can be performed by one or more programmable processors executing a computer program, code or instructions to perform functions (e.g., by operating on input data and/or generating an output). Method steps can also be performed by, and apparatuses described herein can be implemented as, special purpose logic circuitry, e.g., a field programmable gate array (FPGA) or an application-specific integrated circuit (ASIC), for example.

The MCU may be a microprocessor, but in the alternative, may be any conventional processor, controller, microcontroller, or state machine. Alternately, the MCU may also be implemented as a combination of computing devices, e.g., a combination of a DSP and a microprocessor, a plurality of microprocessors, one or more microprocessors in conjunction with a DSP core, or any other such configuration.

Processors suitable for the execution of a computer program include, by way of example, both general and special purpose microprocessors, and any one or more processors of any kind of digital computer. Generally, a processor will receive instructions and data from a read-only memory or a random-access memory or both. The essential elements of a computer are a processor for executing instructions and one or more memory devices for storing instructions and data. Generally, a computer will also include, or be operatively coupled to receive data from or transfer data to, or both, one or more mass storage devices for storing data, e.g., magnetic, magneto-optical disks, or optical disks. Information carriers suitable for embodying computer program instructions and data include all forms of non-volatile memory, including by way of example, semiconductor memory devices, e.g., electrically programmable read-only memory (ROM) (EPROM), electrically erasable programmable ROM (EEPROM), flash memory devices, and data storage disks. The processor and the memory can be supplemented by, or incorporated in special purpose logic circuitry.

Computer-readable non-transitory media includes all types of computer readable media, including magnetic storage media, optical storage media, flash media and solid-state storage media.

It may be understood that the example embodiments described herein may be considered in a descriptive sense only and not for purposes of limitation. Descriptions of features or aspects within each example embodiment may be considered as available for other similar features or aspects in other example embodiments.

While example embodiments have been described with reference to the figures, it will be understood by those of ordinary skill in the art that various changes in form and details may be made therein without departing from the spirit and scope as defined by the following claims.

## Claims

1. A power appliance coupler comprising:
a plug connector configured to connect to a power outlet;
a power outlet port;
a microprocessor;
an infrared "IR" receiver port configured to receive data via an IR signal and communicate the received data to the microprocessor;
an IR transmitter port configured to transmit output data from the microprocessor as an IR signal;
a voltage sensor operatively coupled to the microprocessor, and
a current sensor operatively coupled to the microprocessor.

2. The power appliance coupler of claim 1, further comprising an offline switched mode power supply, operatively coupled to the microprocessor.

3. The power appliance coupler of claim 1 or claim 2, further comprising a visual indicator operatively coupled to the microprocessor

4. The power appliance coupler of any preceding claim, further comprising a power cord fixed to the power outlet port.

5. The power appliance coupler of any preceding claim, wherein the power outlet port comprises an appliance outlet.

6. A power appliance coupler system comprising:
a rack power distribution unit "rPDU" that includes a plurality of power outlets; and
a coupler communicatively coupled to the rPDU;
wherein the coupler includes:
a plug connector configured to connect to one of the plurality of power outlets of the rPDU,
a microprocessor,
an infrared "IR" receiver port configured to receive data via an IR signal and to communicate the received data to the microprocessor,
an IR transmitter port configured to transmit output data from the microprocessor as an IR signal,
a voltage sensor operatively coupled to the microprocessor, and
a current sensor operatively coupled to the microprocessor.

7. The power appliance coupler system of claim 6, further comprising a wired connector operatively connecting the rPDU and the coupler.

8. The power appliance coupler system of claim 6, wherein the coupler is communicatively coupled to the rPDU wirelessly.

9. The power appliance coupler system of any of claims 6-8, wherein the rPDU further includes an input power supply cord.

10. The power appliance coupler system of any of claims 6-9, wherein the rPDU further includes an interchangeable monitoring device "IMD".

11. The power appliance coupled system of any of claims 6-10, wherein the coupler further includes an offline switched mode power supply, operatively coupled to the microprocessor, and/or wherein the coupler further includes a visual indicator operatively coupled to the microprocessor.

12. The power appliance coupled system of any of claims 6-11, wherein the coupler further includes a power outlet port.

13. The power appliance coupled system of claim 12, wherein the coupler further includes a power cord fixed to the power outlet port and/or wherein the power outlet port comprises an appliance outlet.

14. A computer-readable medium storing thereon a program which, when executed by a processor causes a power appliance coupler to:
establish communication with a host of a rack power distribution unit "rPDU";
receive an assigned index and configuration information from the host;
establish communication with a downstream coupler;
assign a next index to the downstream coupler; and
transmit the configuration information to the downstream coupler.

15. The computer-readable medium of claim 14, wherein the program further causes the power appliance coupler to:
receive data and status information from the downstream coupler; and/or
determine a phase relationship and a circuit relationship with the downstream coupler; and/or
transmit phase relationship and circuit relationship information to the host; and/or communicate with the downstream coupler using an infrared "IR" port.
